(19) **Europäisches Patentamt / European Patent Office / Office européen des brevets**

(11) **EP 1 455 452 B1**

(12) **EUROPEAN PATENT SPECIFICATION**

(45) Date of publication and mention
of the grant of the patent:
**09.05.2007 Bulletin 2007/19**

(51) Int Cl.:
*H03K 17/567* (2006.01)   *H03K 17/64* (2006.01)

(21) Application number: **03425140.5**

(22) Date of filing: **05.03.2003**

(54) **Driving circuit for a control terminal of a bipolar transistor in an emitter-switching configuration and corresponding driving method**

Ansteuerschaltung für einen Steueranschluss eines Bipolartransistors, der in der Emitterschattkonfiguration ist und entsprechenes Ansteuerverfahren

Circuit d'excitation pour une borne de commande d'un transistor bipolaire dans la configuration de commutation d'émetteur et procédé d'excitation correspondant

(84) Designated Contracting States:
**DE FR GB IT**

(43) Date of publication of application:
**08.09.2004 Bulletin 2004/37**

(73) Proprietor: **STMicroelectronics S.r.l.**
**20041 Agrate Brianza (Milano) (IT)**

(72) Inventors:
• **Scollo, Rosario**
  **95045 Misterbianco (Catania) (IT)**
• **Buonomo, Simone**
  **96011 Augusta (Siracusa) (IT)**

(74) Representative: **Ferrari, Barbara et al**
**Botti & Ferrari S.r.l.,**
**Via Locatelli, 5**
**20124 Milano (IT)**

(56) References cited:
**US-A- 4 695 770**

• **"SELF-OPTIMIZING LOW ENERGY DRIVE CIRCUIT FOR EMITTER-SWITCHED TRANSISTOR" IBM TECHNICAL DISCLOSURE BULLETIN, IBM CORP. NEW YORK, US, vol. 39, no. 1, 1996, pages 151-160, XP000556356 ISSN: 0018-8689**

## Description

The present invention relates to a driving circuit for a control terminal of a bipolar transistor in the emitter-switching configuration.

More specifically, the invention relates to a driving circuit for a control terminal of a bipolar transistor inserted, in the emitter-switching configuration, between a first and a second voltage references, said driving circuit comprising at least a first resistive element connected to said control terminal and a first capacitor connected to said resistive element in correspondence with a first circuit node and to said second voltage reference.

The invention also relates to a driving method for a control terminal of a bipolar transistor in the emitter-switching configuration.

The invention particularly relates, but not exclusively, to a high breakdown voltage bipolar transistor being cascode-connected to a low voltage MOS transistor in the so-called emitter-switching configuration and the following description is made with reference to this field of application for convenience of illustration only.

Prior art

As it is well known, a so-called emitter-switching circuit configuration comprises a cascode connection of a bipolar transistor having a high breakdown voltage and of a low voltage power MOSFET transistor.

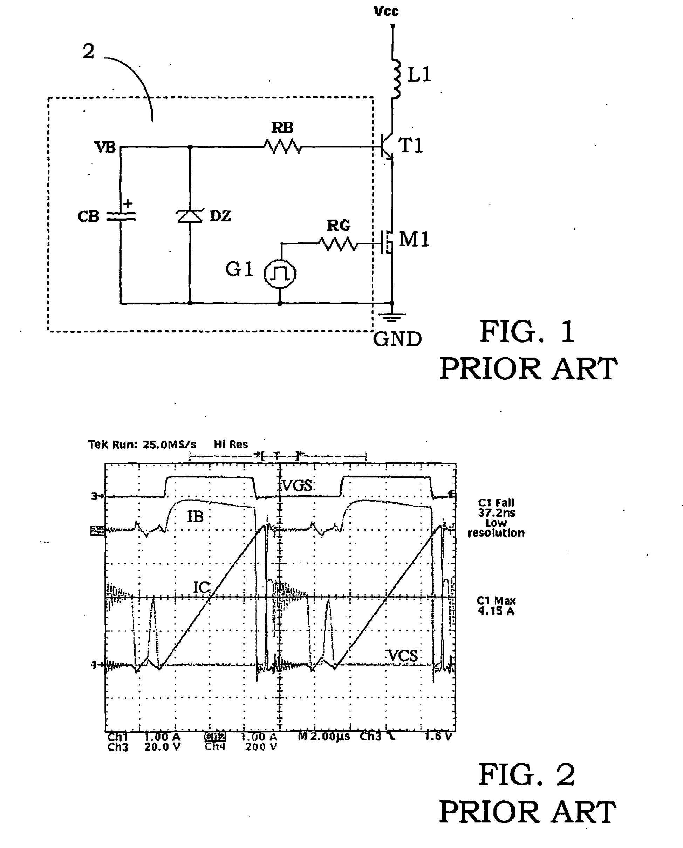

Such a configuration is schematically shown in figure 1 and globally indicated with 1. The emitter-switching configuration 1 comprises a bipolar transistor T1 and a MOS transistor M1, cascode-connected to each other, inserted between a first and a second voltage references, particularly the supply voltage Vcc and the ground GND.

The emitter-switching configuration 1 provides that the bipolar transistor T1 is of the HV (High Voltage) type, i.e. a high breakdown voltage transistor, while the MOS transistor M 1 is of the LV (Low Voltage) type, i.e. a low breakdown voltage transistor.

The bipolar transistor T1 has a collector terminal connected to the supply voltage reference Vcc by means of an inductive load L1 and a control or base terminal connected to a driving circuit 2.

The MOS transistor M 1 has in turn a control or gate terminal connected to the driving circuit 2.

The driving circuit 2 comprises:

- a first resistive element RB connected to the base terminal of the bipolar transistor T1 and, by means of a Zener diode DZ, to the ground GND;

- a second resistive element RG connected to the gate terminal of the MOS transistor M1 and, by means of a voltage pulse generator G1, to the ground GND;

- an electrolytic capacitor CB connected in parallel with the Zener diode DZ and having at the terminals thereof a voltage value equal to VB.

In particular, the electrolytic capacitor CB has the function of storing energy during the bipolar transistor T1 turn-off, in order to reuse it during a following turn-on and conduction step of the transistor itself, while the Zener diode prevents the base voltage value of the bipolar transistor T1 from exceeding a predetermined threshold.

The emitter-switching configuration, known for a long time to the skilled in the art, is at present particularly interesting due to the marketing of bipolar transistors having a square RBSOA [Reverse Biased Safe Operating Area] (in the emitter-switching configuration) with a current near to the peak current and a voltage equal to the breakdown voltage BVCES between the collector and emitter terminals when the base terminal is short-circuited with the emitter terminal [Breakdown Voltage Collector-Emitter Short], as well as of MOS power transistors having a very low drain-source resistance value in conduction conditions, $R_{DSON}$, and being thus almost similar to ideal switches.

Such circuits are known from US 4 695 770 A and IBM Technical Disclosure Bulletin, Vol 39, No 1 pp 151-160.

The emitter-switching configuration main advantages are, as everybody knows, an extremely low in-conduction voltage drop (typical of bipolar transistors) and a high turn-off speed.

In fact, when turning off, the current outputted from the bipolar transistor base terminal is equal to the collector terminal current of this transistor, i.e. a very high current. This causes a drastic reduction both of the storage time and of the fall time, allowing the emitter-switching configuration to operate even at frequencies of 150 kHz.

The driving performed through the driving circuit 2 is very useful and effective in all those cases in which the current in the emitter-switching configuration 1 is void, or very small with respect to the nominal current, in the turn-on step.

For this driving to be effective, it is however necessary that the base current value in the turn-off step, $I_{BOFF}$, multiplied by the storage time, $t_{storage}$, is near to the base current value in the conduction step, $I_{BON}$, multiplied by the turn-on time $t_{on}$, that is:

$$I_{BOFF}{}^{*}t_{storage} \approx I_{BON}{}^{*}t_{ON}$$

The condition (1) usually occurs when operating at relatively high frequencies and with not too high currents, or better when the bipolar transistor gain value hfe is not too low.

In fact, in this case, the driving energy required for the conduction is slightly higher than the energy recovered during the turn-off. It is thus sufficient to supply the base terminal with a very low power to replace inevitable losses.

Figure 2 shows the trend of voltage VGS values between the gate and source terminals of the MOS transistor M1, of the voltage between the bipolar transistor collector terminal and the MOS transistor source terminal, VCS, and of the base and collector currents of the bipolar transistor T1 with reference to a flyback converter operating at a frequency of 100 kHz and having a void turn-on current since the converter operates discontinuously.

When operating with applications wherein the current value on the emitter-switching configuration 1 in the turn-on step is not void, and at higher frequencies than around sixty kHz, the so-called phenomenon of the dynamic VCESAT voltage between the bipolar transistor collector and emitter terminals involves excessive power dissipations. This phenomenon consists in that, when turning on, there is a certain delay before reaching the static VCESAT voltage value, and it is thus necessary to overflow with carriers the bipolar transistor base region as fast as possible in order to make the VCESAT voltage value decrease and reach as soon as possible the steady value.

It is evident that the higher the bipolar transistor operating frequency is the more this phenomenon is relevant. The need for a high turn-on base current is however in contrast with the need for a reasonable saturation in the turn-off step. In fact, the benefits of an improved turn-on current-voltage crossing would be lost in the turn-off step.

For this reason the need arises for a particular modulation of the bipolar transistor base current in the emitter-switching configuration, which allows both switching steps (turn-on and turn-off) to be optimised and the minimum VCESAT voltage value to be reached.

The technical problem underlying the present invention is to provide a driving circuit of an emitter-switching configuration, having such structural and functional characteristics as to allow the base current of the bipolar transistor comprised in this configuration to be modulated, overcoming therefore the limits and drawbacks still affecting prior art driving circuits.

Summary of the invention

The solutive idea underlying the present invention is to provide at least a pair of voltage values to be applied to the bipolar transistor base terminal in the emitter-switching configuration.

On the basis of this solutive idea the technical problem is solved by a driving circuit as previously indicated and defined in the characterising part of claim 1.

The technical problem is also solved by a driving method as previously indicated and defined in the characterising part of claim 8.

The features and advantages of the driving circuit and method according to the invention will be apparent from the following description of an embodiment thereof given by way of non-limiting example with reference to the attached drawings.

Brief description of the drawings

In the drawings:

- Figure 1 schematically shows a driving circuit for an emitter-switching configuration according to the prior art;

- Figure 2 schematically shows the trend of waveforms typical of a discontinuous flyback converter according to the prior art;

- Figure 3 schematically shows a driving circuit for a bipolar transistor in the emitter switching configuration according to the invention;

- Figure 4 shows the trend of waveforms obtained with the driving circuit according to the invention and shown in figure 3;

- Figure 5 shows the trend of waveforms obtained with the known driving circuit of figure 1;

- Figure 6 shows the trend of waveforms in the turn-on step of the driving circuit according to the invention and shown in figure 3;

- Figure 7 shows the trend of waveforms in the turn-on step of the known driving circuit of figure 1;

- Figure 8 shows the voltage trend between the bipolar transistor collector terminal and the MOS transistor source terminal (VCS) of an emitter-switching configuration associated to the driving circuit according to the invention and shown in figure 3;

- Figure 9 shows the voltage trend between the bipolar transistor collector terminal and the MOS transistor source terminal (VCS) of an emitter-switching configuration associated to the known driving circuit of figure 1;

- Figure 10 shows the trend of waveforms in the turn-off step of the driving circuit according to the invention and shown in figure 3;

- Figure 11 shows the trend of waveforms in the turn-off step of the known driving circuit of figure 1.

Detailed description

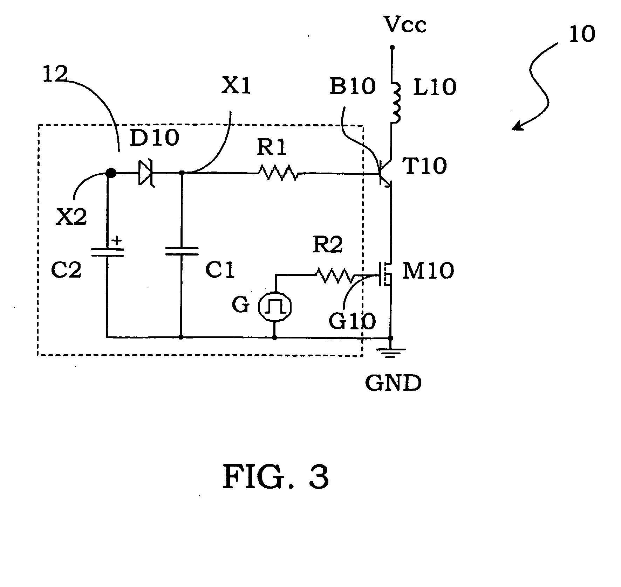

With reference to the figures, and particularly to figure 3, a known emitter-switching configuration associated to a driving circuit 12 according to the invention has been globally and schematically indicated with 10.

As it has been seen with reference to the prior art, the emitter-switching configuration 10 comprises a bipolar transistor T10 and a MOS transistor M10, cascode-connected to each other, inserted between a first and a second voltage references, particularly the supply voltage Vcc and the ground GND.

The emitter-switching configuration 10 provides that the bipolar transistor T10 is of the HV (High Voltage) type, i.e. a high breakdown voltage transistor, while the MOS transistor M10 is of the LV (Low Voltage) type, i.e. a low breakdown voltage transistor.

The bipolar transistor T10 has a collector terminal connected to the supply voltage reference Vcc by means of an inductive load L10 and a control or base terminal B10 connected to the driving circuit 12.

The MOS transistor M10 has in turn a control or gate terminal G10 connected to the driving circuit 12.

The driving circuit 12 comprises:

- a first resistive element R1 connected to the base terminal B10 of the bipolar transistor T10; and

- a second resistive element R2 connected to the gate terminal G10 of the MOS transistor M10 and, by means of a voltage pulse generator G10, to the ground GND.

Advantageously according to the invention, the driving circuit 12 comprises a first and a second capacitor C 1 and C2, as well as a Zener diode D10. In particular, this second capacitor C2 is of the electrolytic type.

The first capacitor C1 is connected to the first resistive element R1 (in correspondence with a first circuit node X1) and to the ground GND. Similarly, the second capacitor C2 is connected to a second circuit node X2 and to the ground GND. As shown in figure 3, the second capacitor C2 has the positive plate connected to the second circuit node X2.

Moreover, the Zener diode D10 is inserted between the first X1 and the second X2 circuit nodes and, particularly, it has a cathode terminal connected to the first circuit node X1 and an anode terminal connected to the second circuit node X2.

Always with reference to figure 3, it is possible to describe the driving method according to the invention.

In particular, the method according to the invention allows the control terminal B10 of the bipolar transistor T10 in the emitter-switching configuration (10) to be driven and it provides the following steps of:

- applying a first voltage value V1 to the control terminal B10 by means of the first capacitor C1; and

- applying a second voltage value V2 to the control terminal B10 by means of the second capacitor C2,

the first voltage value V1 being higher than the second voltage value V2.

Advantageously according to the invention, the second voltage value V2 is kept constant by the second capacitor C2, while the first voltage value V1 is caused to vary according to need by varying the value of the first capacitor C1 and of the Zener diode D10.

As it will be better seen afterwards, the driving circuit 12 according to the invention is optimal from the performance and cost point of view, the simplicity and efficacy thereof being its strong points.

In particular, the driving circuit 12 according to the invention is particularly effective in the following conditions:

- Higher frequency than 60 kHz

- Relatively low duty cycle (> 30%)

- Current IC on the bipolar transistor collector terminal being different from zero in the turn-on step.

In fact it is worth noting that the above-mentioned conditions are those in which the problem of the dynamic VCESAT voltage between the collector and emitter terminals becomes considerable. In fact at high frequency and with a low duty cycle, the total conduction time is very short and, adding thereto a not-void value of the collector current when turning on, it can be clearly observed that the voltage VCE between the collector and emitter terminals has difficulty in reaching the saturation value, unless, when turning on, the current IB of the base terminal is particularly high.

The driving circuit 12 according to the invention allows a starting peak of the base current IB being as high as desired to be obtained, while the emitter-switching configuration 10 ensures a turn-off current $I_{BOFF}$ being as high and thus small tstorage storage time values.

In fact, advantageously according to the invention, the voltage value V2 on the second circuit node X2 is kept constant, due to the presence of the second capacitor C2, while the highest voltage value V1 on the first circuit node X1 is caused to vary according to need, by acting on the values of the first capacitor C1 and of the Zener diode D10.

In particular, since it is necessary to obtain a very high base current value IB during the turn-on, it is required that the voltage V1 is higher than V2 during the turn-on. To attain this purpose, through the driving circuit 12 according to the invention, it is sufficient to choose a relatively low value of the first capacitor C1. For example, for operating frequencies comprised between 60 and 150 kHz the value of the first capacitor C1 is preferably chosen between 680 and 180 nF. For an operating frequency of 100 kHz, the value of the first capacitor C1 can be chosen between 200 and 300 nF.

In fact it is worth noting that the highest possible value of the base current IB during the turn-on depends on the value of this first capacitor C1, as well as the duration of the starting current spike. The lowest the value of the first capacitor C1 is, the shortest the duration of this spike is.

Moreover it must be observed that the value of the resistive element R1 connected to the base terminal B10 of the bipolar transistor T10 is advantageously chosen low (0.33 Ω) and it contributes to determining the base current IB both during the turn-on and in the conduction step.

The main advantages of the driving circuit 12 according to the invention are thus:

- the control of the highest value of the base current IB of the bipolar transistor T10 by controlling the highest voltage value on the first capacitor C 1;

- the total energy recovery when turning off; and

- the structural simplicity of the circuit itself.

The driving circuit 12 according to the invention allows the current IB of the base terminal B10 of the bipolar transistor T10 to be controlled by means of the Zener diode D10 which fixes precisely the highest voltage value V1 on the first circuit node X1 (with respect to the voltage value V2 on the second circuit node X2) which determines in turn the base current IB peak.

Another important advantage of the driving circuit 2 according to the invention is the possibility to vary the voltage V2 on the second circuit node X2, with a negligible influence on the turn-on base current IB, in order to vary the highest value during the conduction, which fixes in turn the saturation condition of the emitter-switching configuration 10.

In order to verify the operation of the driving circuit 12 according to the invention with an emitter-switching configuration 10 as described, the Applicant has performed a simulation in a so-called forward converter operating at a frequency of 110 kHz, with a duty cycle, at the highest operating power, slightly higher than 20% and with a higher turn-on current ICturn-ON than the turn-off current ICOFF.

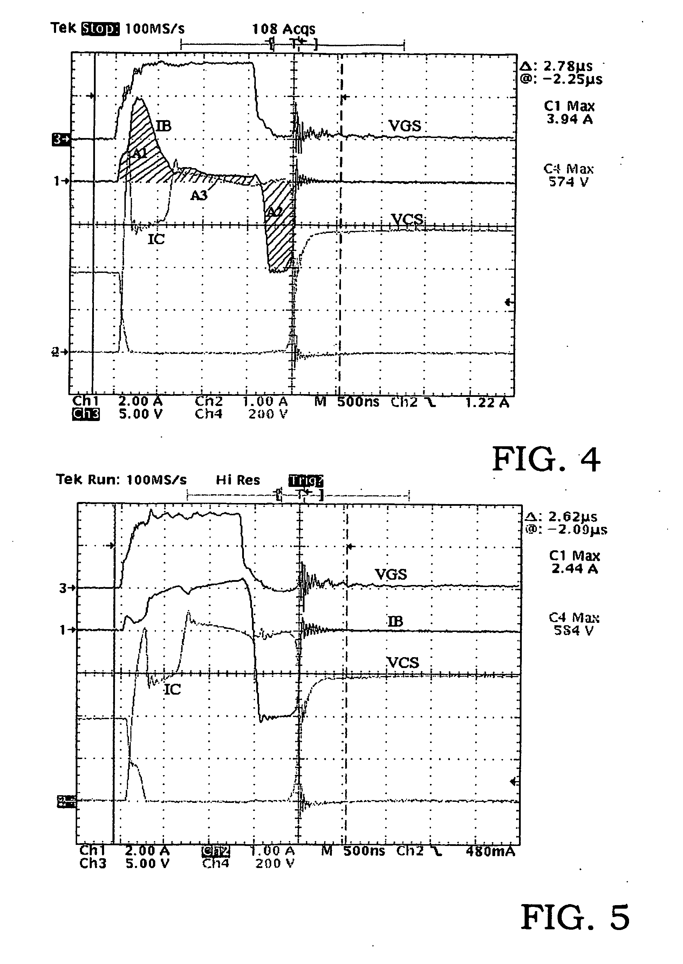

The results obtained are indicated in figures 4, 6, 8 and 10, while figures 5, 7, 9 and 11 represent by way of comparison the waveforms corresponding to a traditional driving circuit.

In particular, figure 4 represents the waveforms obtained by driving the emitter-switching configuration by means of the driving circuit 12 according to the invention as shown in figure 3, while figure 5 represents the waveforms corresponding to a same emitter-switching configuration 1 driven by means of a driving circuit according to the prior art, as the one shown in figure 1.

It can be thus verified that the trend of the base current IB shown in figure 4 allows the emitter-switching configuration to be rapidly turned on and the desired saturation level to be reached. This is possible through the two voltage levels V1 and V2 applied to the bipolar transistor base terminal B10, generated by the driving circuit 12 according to the invention.

From a comparison with the trend of that current represented in figure 5, it is evident that the turn-on step is clearly better with the driving circuit 12 according to the invention.

Moreover, it is worth noting that the supply voltage applied to the base terminal (VB) is higher in the traditional driving circuit than voltage V2; this leads to a higher storage time and thus to a slower emitter-switching configuration turn-off.

With the driving circuit 2 according to the prior art, by supplying that base terminal with a slightly lower voltage value, an improved emitter-switching configuration turn-off could be obtained, but only to the detriment of a further deterioration of the already terrible current-voltage crossing in the turn-on step.

It must also be noted that the dissipated power for driving the base terminal is very low with the driving circuit 12 according to the invention, as it is in the case of the known driving circuit. In fact, the amount of charge supplied during the turn-on step is almost equal to the one recovered during the turn-off step.

Always with reference to figure 4, it can be easily verified that the integration area A1 is almost equal to the integration area A2. In other words, the amount of charge which must be provided through an external supply is only the one represented by the integration area A3.

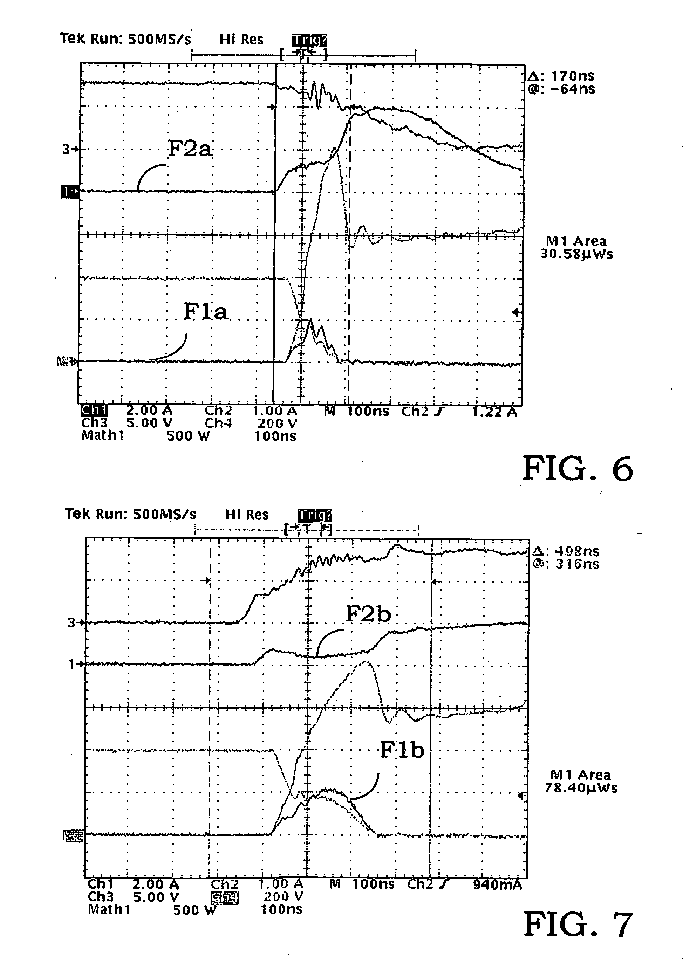

Figures 6 and 7 represent the waveforms corresponding particularly to the turn-on of the two driving circuits of figure 3 and 1 respectively. Waveforms F1a and F1b are the instantaneous power dissipated by the emitter-switching configuration, i.e. the product between the voltage VCS and the collector current IC. The area subtended by these curves is thus an energy, and, particularly, the energy dissipated during the turn-on. It is thus evident how to obtain, with the driving circuit 12 according to the invention, a reduction to almost one third both of the turn-on time and of the energy dissipated at the turn-on.

Waveforms F2a and F2b are instead the base terminal current. In particular, figure 6 shows how the Vb value which, at the turn-on, leads to a very high base current value IB, starts then decreasing to finally reach the steady value equal to V1 less the voltage drop on the Zener diode D10. At the same time, the base current IB, after reaching the maximum, decreases so as to stabilise at the value set just by V2 (as shown also in figure 4).

Moreover it is worth noting that the dynamic VCESAT phenomenon which, as seen, involves the problem of the excessive turn-on dissipation, also affects the losses during the conduction step. In fact, without the turn-on base current IB spark, by driving the bipolar transistor with the driving circuit 2 according to the prior art, the voltage VCE between the collector and emitter terminals does not succeed in reaching the static VCESAT value in less than 2 ÷ 3 μs.

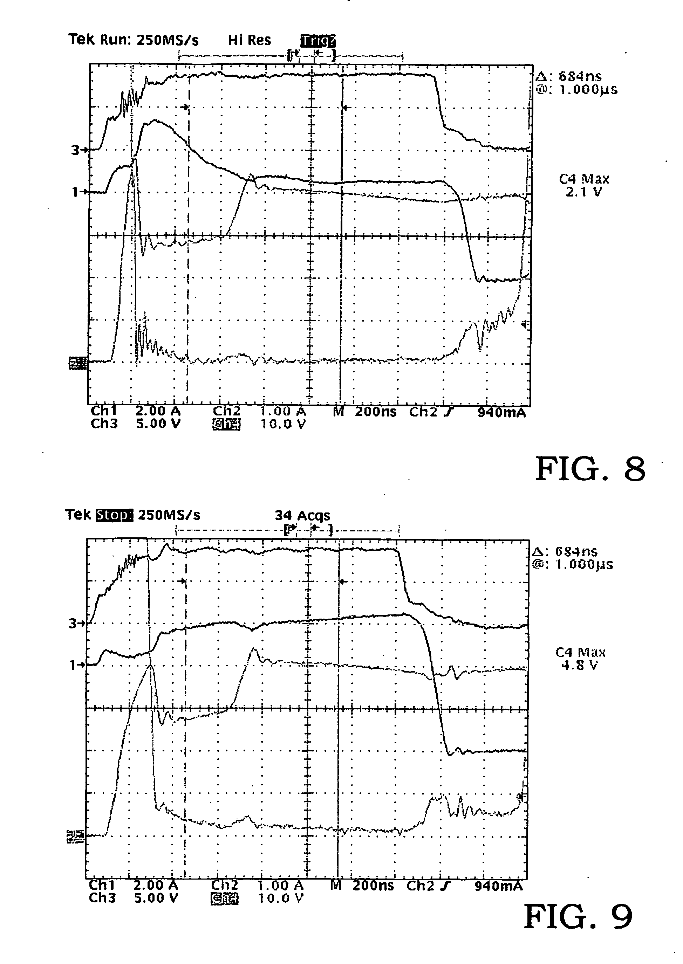

With reference to figures 8 and 9, it is possible to note how the voltage VCS value determined by the driving circuit 12 according to the invention reaches the static value in little more than 200 ns (figure 8), when the driving circuit 2 according to the prior art is used, the voltage VCS does not succeed in reaching the static value before the following turn-off of the emitter-switching configuration.

To avoid any misunderstanding, it is specified that, speaking of voltage VCS is equal to speaking of voltage VCE between the collector and emitter terminals since the following relation applies:

$$VCS = VCE + VDSON$$

and since the voltage VDSON reaches very rapidly the steady value.

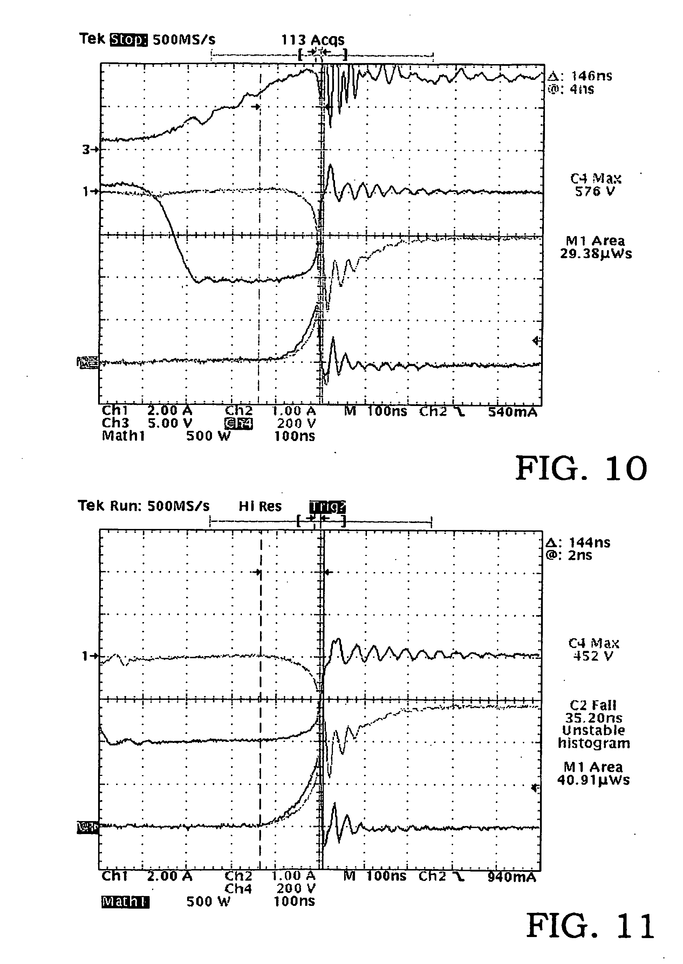

From the simulations performed, also differences in the power dissipated in the turn-off step arise, as it can be observed from the trends represented in figures 10 and 11. In particular, the known driving circuit 2 involves a slower turn-off, with an increase both in the storage time and in the fall time; this leads, as a consequence, to a deterioration of the current-voltage crossing and thus to a higher turn-off dissipation.

**Claims**

1. A driving circuit for a control terminal (B10) of a bipolar transistor (T10) inserted, in the emitter-switching configuration, between a first (Vcc) and a second (GND) voltage references, said driving circuit comprising at least a first resistive element (R1) connected to said control terminal (B10) and a first capacitor (C1) connected to said resistive element (R1) in correspondence with a first circuit node (X1) and to said second voltage reference (GND), **characterised in that** it further comprises a Zener diode (D10) connected between said first circuit node (X1) and a second circuit node (X2) as well as a second capacitor (C2), inserted between said second circuit node (X2) and said second reference voltage (GND).

2. A driving circuit according to claim 1, **characterised in that** said first capacitor (C1) has a lower value than said second capacitor (C2).

3. A driving circuit according to claim 1, **characterised in that** said Zener diode (D10) has a cathode terminal connected to said first circuit node (X1) and an anode terminal connected to said second circuit node (X2).

4. A driving circuit according to claim 1, **characterised in that** said second capacitor (C2) is of the electrolytic type.

5. A driving circuit according to claim 1, **characterised in that** said second capacitor (C2) has the positive plate connected to said second circuit node (X2).

6. A driving circuit according to claim 1, **characterised in that** said first capacitor (C1) has a conveniently low value, preferably comprised between 680 and 180 nF for operating frequencies comprised between 60 and 150 kHz.

7. A driving circuit according to claim 1, **characterised in that** said first resistive element (R1) has a lower value than 0.5 Ω, preferably equal to 0.33 Ω.

8. A method for driving a control terminal (B10) of a bipolar transistor (T10) inserted, in the emitter-switching configuration (10), between a first and a second voltage references (Vcc, GND) **characterised in that** it provides the steps of:

   - applying a first voltage value (V1) to said control terminal (B10) by means of a first capacitor (C1) connected to said control terminal (B10) by means of a resistive element (R1); and
   - applying a second voltage value (V2) to said control terminal (B10) by means of a second capacitor (C2) connected to said control terminal (B10) by means of the series of a Zener diode (D10) and of said resistive element (R1),

   said first voltage value (V1) being higher than said second voltage value (V2).

9. A driving method according to claim 8, **characterised in that** said second voltage value (V2) is kept constant by said second capacitor (C2).

10. A driving method according to claim 8, **characterised in that** said first voltage value (V1) is caused to vary according to need by varying the value of said first capacitor (C1) and said Zener diode (D10)

**Patentansprüche**

1. Ansteuerschaltung für einen Steueranschluss (B10) eines Bipolartransistors (T10), der in der Emitterschaltkonfiguration zwischen einer ersten (Vcc) und einer zweiten (GND) Spannungsreferenz eingefügt ist, wobei die Ansteuerschaltung wenigstens ein erstes, an den Steueranschluss (B10) angeschlossenes Widerstandselement (R1) umfasst, und einen ersten Kondensator (C1), der an das Widerstandselement (R1) in Entsprechung mit einem ersten Schaltungsknoten (X1) und an die zweite Spannungsreferenz (GND) angeschlossen ist, **dadurch gekennzeichnet, dass** sie darüber hinaus eine Zenerdiode (D10) umfasst, die zwischen dem ersten Schaltungsknoten (X1) und einem zweiten Schaltungsknoten (X2) angeschlossen ist, sowie einen zweiten Kondensator (C2), der zwischen dem zweiten Schaltungsknoten (X2) und der zweiten Referenzspannung (GND) eingefügt ist.

2. Ansteuerschaltung nach Anspruch 1, **dadurch gekennzeichnet, dass** der erste Kondensator (C1) einen niedrigeren Wert als der zweite Kondensator (C2) hat.

3. Ansteuerschaltung nach Anspruch 1, **dadurch gekennzeichnet, dass** die Zenerdiode (D10) einen Kathoden-Anschluss hat, der an den ersten Schaltungsknoten (X1) angeschlossen ist, und einen Anoden-Anschluss, der an den zweiten Schaltungsknoten (X2) angeschlossen ist.

4. Ansteuerschaltung nach Anspruch 1, **dadurch gekennzeichnet, dass** der zweite Kondensator (C2) in Elektrolyt-Bauart ausgeführt ist.

5. Ansteuerschaltung nach Anspruch 1, **dadurch gekennzeichnet, dass** in den zweiten Kondensator (C2) die positive Platte an den zweiten Schaltungsknoten (X2) angeschlossen ist.

6. Ansteuerschaltung nach Anspruch 1, **dadurch gekennzeichnet, dass** der erste Kondensator (C1) einen zweckmäßig niedrigen Wert hat, der für Betriebsfrequenzen zwischen 60 und 150 kHz vorzugsweise zwischen 680 und 180 nF liegt.

7. Ansteuerschaltung nach Anspruch 1, **dadurch gekennzeichnet, dass** das erste Widerstandselement (R1) einen Wert von unter 0,5 Ω hat, vorzugsweise gleich 0,33 Ω.

8. Verfahren zum Ansteuern eines Steueranschlusses (B10) eines Bipolartransistors (T10), der in der Emitterschaltkonfiguration (10) zwischen einer ersten und einer zweiten Spannungsreferenz (Vcc, GND) eingefügt ist, **dadurch gekennzeichnet, dass** es folgende Schritte vorsieht:

- Anlegen eines ersten Spannungswerts (V1) an den Steueranschluss (B10) durch einen ersten Kondensator (C1), der über ein Widerstandselement (R1) an den Steueranschluss (B10) angeschlossen ist; und
- Anlegen eines zweiten Spannungswerts (V2) an den Steueranschluss (B10) durch einen zweiten Kondensator (C2), der über die Hintereinanderschaltung einer Zenerdiode (D10) und des Widerstandselements (R1) an den Steueranschluss (B10) angeschlossen ist,

wobei der erste Spannungswert (V1) höher ist als der zweite Spannungswert (V2).

9. Ansteuerverfahren nach Anspruch 8, **dadurch gekennzeichnet, dass** der zweite Spannungswert (V2) durch den zweiten Kondensator (C2) konstant gehalten wird.

10. Ansteuerverfahren nach Anspruch 8, **dadurch gekennzeichnet, dass** man den ersten Spannungswert (V1) dem Bedarfsfall entsprechend sich verändern lässt, indem der Wert des ersten Kondensators (C1) und der Zenerdiode (D10) verändert wird.

## Revendications

1. Circuit d'excitation pour une borne de commande (B10) d'un transistor bipolaire (T10) inséré, dans la configuration de commutation d'émetteur, entre une première référence de tension (Vcc) et une deuxième référence de tension (GND), ledit circuit d'excitation comprenant au moins un premier élément résistif (R1) connecté à ladite borne de commande (B10) et une première capacité (C1) connectée au dit élément résistif (R1) correspondant à un premier noeud de circuit (X1) et à ladite deuxième tension de référence (GND), **caractérisé en ce qu'**il comprend en outre une diode Zener (D10) connectée entre ledit premier noeud de circuit (X1) et un deuxième noeud de circuit (X2) ainsi qu'une deuxième capacité (C2), insérée entre ledit deuxième noeud de circuit (X2) et ladite deuxième tension de référence (GND)

2. Circuit d'excitation selon la revendication 1, **caractérisé en ce que** ladite première capacité (C1) a une valeur inférieure à celle de ladite deuxième capacité (C2)

3. Circuit d'excitation selon la revendication 1, **caractérisé en ce que** ladite diode Zener (D10) a une borne de cathode connectée au dit premier noeud de circuit (X1) et une borne d'anode connectée au dit deuxième noeud de circuit (X2).

4. Circuit d'excitation selon la revendication 1, **caractérisé en ce que** ladite deuxième capacité (C2) est de type électrolytique.

5. Circuit d'excitation selon la revendication 1, **caractérisé en ce que** ladite deuxième capacité (C2) a la plaque positive connectée au dit deuxième noeud de circuit (X2).

6. Circuit d'excitation selon la revendication 1, **caractérisé en ce que** ladite première capacité (C1) a une valeur opportunément basse, comprise de préférence entre 680 et 180 nF afin de fonctionner à des fréquences comprises entre 60 et 150 kHz.

7. Circuit d'excitation selon la revendication 1, **caractérisé en ce que** ledit premier élément résistif (R1) a une valeur inférieure à 0,5 Ω, de préférence égale à 0,33 Ω.

8. Procédé pour exciter une borne de commande (B10) d'un transistor bipolaire (T10) inséré, dans la configuration de commutation d'émetteur (10), entre une première et une deuxième tensions de référence (Vcc, GND) **caractérisé en ce qu'**il dispose des étapes consistant à :

   - appliquer une première valeur de tension (V1) à ladite borne de commande (B10) au moyen d'une première capacité (C1) connectée à ladite borne de commande (B10) au moyen d'un élément résistif (R1) ; et
   - appliquer une deuxième valeur de tension (V2) à ladite borne de commande (B10) au moyen d'une deuxième capacité (C2) connectée à ladite borne de commande (B10) au moyen d'une diode Zener (D10) et dudit élément résistif (R1) connectés en série,

   ladite première valeur de tension (V1) étant supérieure à ladite deuxième valeur de tension (V2)

9. Procédé d'excitation selon la revendication 8, **caractérisé en ce que** ladite deuxième valeur de tension (V2) est maintenue constante par ladite deuxième capacité (C2).

10. Procédé d'excitation selon la revendication 8, **caractérisé en ce que** l'on fait varier selon les besoins ladite première valeur de tension (V1) en variant la valeur de ladite première capacité (C1) et de ladite diode Zener (D10)

FIG. 1
PRIOR ART

FIG. 2
PRIOR ART

FIG. 3

FIG. 4

FIG. 5

FIG. 6

FIG. 7

Tek Run: 250MS/s      HI Res      Trig?

Δ: 684ns
@: 1.000μs

C4 Max
2.1 V

Ch1   2.00 A     Ch2   1.00 A     M 200ns   Ch2 ⌐   940mA
Ch3   5.00 V              10.0 V

## FIG. 8

Tek Stop 250MS/s      34 Acqs

Δ: 684ns
@: 1.000μs

C4 Max
4.8 V

Ch1   2.00 A     Ch2   1.00 A     M 200ns   Ch2 ⌐   940mA
Ch3   5.00 V              10.0 V

## FIG. 9

FIG. 10

FIG. 11